# EUROPEAN PATENT SPECIFICATION

(11) **EP 0 638 926 B1**
(45) Date of publication and mention of the grant of the patent: **21.04.2004**
(21) Application number: 94303200.3
(22) Date of filing: 03.05.1994
(51) Int. Cl.: H01L 21/60

(54) **Process of fabricating semiconductor unit employing bumps to bond two components**
Herstellungsverfahren für eine Halbleitereinheit, wobei Höcker zum Bonden von zwei Bauelementen verwendet werden
Procédé de fabrication d'une unité semi-conductrice utilisant des bosses pour lier deux composants

(30) Priority: 13.08.1993 JP 20170493
(43) Date of publication of application: 15.02.1995
(73) Proprietor: FUJITSU LIMITED, Kawasaki-shi, Kanagawa 211 (JP)
(72) Inventor: Karasawa, Kazuaki, c/o Fujitsu Limited, Kawasaki-shi, Kanagawa 211 (JP); Nakanishi, Teru, c/o Fujitsu Limited, Kawasaki-shi, Kanagawa 211 (JP); Hashimoto, Kaoru, c/o Fujitsu Limited, Kawasaki-shi, Kanagawa 211 (JP); Sakamura, Toshihiro, c/o Fujitsu Limited, Kawasaki-shi, Kanagawa 211 (JP)
(74) Representative: Silverman, Warren

(56) References cited:
- EP-A- 0 147 576
- EP-A- 0 191 434
- EP-A- 0 358 867
- EP-A- 0 463 297
- US-A- 5 125 560
- PATENT ABSTRACTS OF JAPAN vol. 006, no. 132 (E-119) 17 July 1982 & JP 57 056 937 A (FUJITSU LTD) 05 April 1982
- PATENT ABSTRACTS OF JAPAN vol. 017, no. 173 (E-1345) 02 April 1993 & JP 04 328 843 A (MATSUSHITA ELECTRIC IND CO LTD) 17 November 1992
- Non-contact external appearance inspection apparatus Y. Okugi & Y Fukazumi Nov. 1992

## Description

The present invention relates to a process of fabricating a semiconductor unit employing a flipchip function.

Recently, high-speed operation has been demanded of semiconductor units. Thus, not only highspeed operation of semiconductor devices themselves but also shortening of circuit lengths between the semiconductor devices are required. For this purpose, the miniaturization of semiconductor devices and narrowing of bonding pitches are needed. The shortening of the total circuit length may be achieved by soldering electronic devices to substrates using lead-less chip carriers (LCC) and flip chip bonding.

In order to secure an electronic device such as a semiconductor device onto a substrate, solder bumps are formed on at least a first one of the electronic device and the substrate. Then, the said first one is positioned on the second of the electronic device and the substrate so that the thus-formed bumps meet the corresponding electrodes provided on the said second one. Then, the bumps are made to reflow so that the bumps join the electronic device onto the substrate. In this case, flux is used.

The flux acts to provisionally maintain the spatial relationship between the electronic device and the substrate by lying between the bumps and the second one of the electronic device and the substrate. The flux further acts to create sufficient wetting conditions between the solder bumps and the corresponding electrodes.

However, the flux may cause problems as described below. The flux is cleaned away after bonding has been completed. If any residue of flux is left after cleaning, the active ingredients contained therein may cause corrosion. Furthermore, the toxicity of the flux may pollute the environment if the liquid waste produced in cleaning is discharged.

In addition, flux cleaning may become difficult if the distances between the components or semiconductor devices and the substrates are made small so as to shorten the total circuit length. In particular, if the flip chip bonding is applied to the solder bonding, since the distance between the semiconductor device and the substrate to be joined together is short, flux cleaning is difficult, and checking the effectiveness of flux cleaning is also difficult.

On the other hand, omission of flux application to the solder bonding may result in poor bonding because of insufficient wetting conditions between the bumps and the electrodes. Displacement positioning errors may also occur between the electronic device and the substrate during the period between the initial positioning process and the actual solder bonding process.

In order to achieve sufficient wetting conditions between the electronic device and the substrate without using flux at the solder joining process, the following methods may be used for example: Before the solder joining process, oxide and hydroxide are removed from the bumps using flux, dry-etching or the like; and then the solder joining is performed in an inert atmosphere. (See Japanese Laid-Open Patent Application No.62-71908, Japanese Laid-Open Patent Application No.62-276518, Japanese Laid-Open Patent Application No.2-303676, Japanese Laid-Open Patent Application No.3-138941, Japanese Laid-Open Patent Application No.3-138942, and Japanese Laid-Open Patent Application No.3-171643)

However, since no means (such as flux) is used to provisionally fix the electronic device onto the substrate, the above-mentioned positioning errors may occur. Further, large-scale equipment is needed for removing oxide films formed on the solder bump surfaces by means of the dry-etching method.

In order to avoid the positioning errors without using flux, a thermo-compression fixing method and a fixing method employing a soft metal or the like may be used. (See Japanese Laid-Open Patent Application No.59-072795, Japanese Laid-Open Patent Application No.62-245640, Japanese Laid-Open Patent Application No.1-192126, Japanese Laid-Open Patent Application No.2-232946, Japanese Laid-Open Patent Application No.3-71649, Japanese Laid-Open Patent Application No.3-171643, and Japanese Laid-Open Patent Application No.3-217024.)

However, the provisional fixing of the electronic device and substrate may include the following problems. If the heights of the solder bumps formed on the first one of the electronic device and substrate are different from one another, some bumps may not come into contact with the corresponding electrodes after the provisional fixing process has been performed. Also, if the heights of the bumps measured before the bonding process are less than the distance between the electronic device and substrate measured after the solder bonding process, there may have been a problem in the solder bonding process. There, inspection work to find the problems appearing in both the provisional fixing process and solder joining process is difficult. Thus, the reliability of the resulting semiconductor unit may be degraded.

EP-A-463297, US-A-5125560, EP-A-147576 and JP-A-57056937 also disclose methods of joining an electronic device to a substrate.

An object of the present invention is to provide a semiconductor-unit fabrication process which enables improvement of the reliability of the resulting semiconductor unit even if the bump heights measured before the provisional fixing process are different.

According to the present invention, there is provided a semiconductor unit fabrication process according to claim 1.

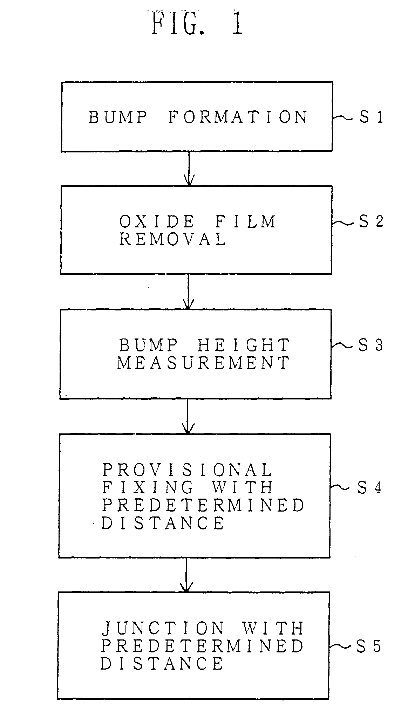

One embodiment of a fabrication process according to the present invention includes the steps shown in FIG. 1.

In FIG. 1, in step S1 (the term "step" is omitted hereinafter) the predetermined number of bumps are formed on at least a first one of the electronic device and the substrate. In S2, the oxide film on the surfaces of the thus-formed bumps is removed. In S3, the heights of all of the bumps are measured. In S4, the electronic device is provisionally fixed onto the substrate using a press fixing method, with the distance therebetween depending on the result of the height measurement performed in S2. In S5, the bumps are then caused to reflow in a predetermined atmosphere at the above distance so that the electronic device is permanently fixed and joined to the substrate.

The performance of S3 and the application of the result of S3 to at least one of S4 and S5 can prevent problematic bonding due to the fact that the height difference between the bumps, appearing before the provisional fixing process, can be prevented from occurring. Thus, reliable solder bonding result can be achieved. Furthermore, since press fixing is employed for provisional fixing instead of the flux application, the above-described problems due to the flux residue may be eliminated. Thus, the reliability of the relevant bonding can be improved and the above-mentioned environmental problem can also be eliminated.

For a better understanding of the invention, and to show how the same may be carried into effect, reference will now be made, by way of example, to the accompanying drawings, in which:-
FIG. 1 shows a basic process of the present invention;
FIGS. 2A-2D show fabrication process diagrams in a first embodiment of the present invention;
FIGS. 3A-3E show fabrication process diagrams of bump formation and oxide film removal steps in either of the first and the second embodiments of the present invention;
FIG. 4 shows bump-height measurement equipment to be used for a bump height measurement step in either of the first and second embodiments of the present invention;
FIG. 5 shows a semiconductor unit employing flip chip bonding according to either of the first and second embodiments of the present invention; and
FIGS. 6A-6D show fabrication process diagrams in the second embodiment of the present invention.

Referring to regard to FIGS. 2A-2D, a first embodiment of the process of the present invention is described. In FIG. 2A, a semiconductor chip 11 of an electronic device includes a predetermined number of electrode pads 12, the predetermined number depending on the function to be provided by the semiconductor unit. Onto each of the electrode pads 12, a bump 13 of Sn-95Pb solder, for example, is formed using plating technology.

Then, oxide films (which may comprise oxide and hydroxide) formed on the surfaces of the thus-formed bumps 13 are removed.

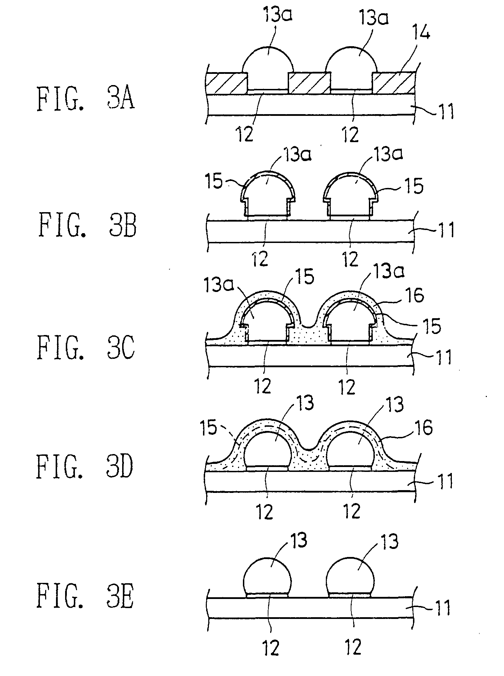

With reference to FIGS. 3A-3E, the above bump formation and oxide film removal steps of FIG. 2A are now described in more detail. As shown in FIG. 3A, a resist 14 is applied to the semiconductor chip 11 where the electrode pads 12 are to remain uncovered, by means of photo-lithography technology. Then, the above-mentioned Sn-95Pb solder is deposited on the exposed pads 12 using plating technology so that the bumps 13a are formed.

Then, as shown in FIG. 3B, the resist 14 is removed, leaving the bumps 13a. A film 15 of oxide or hydroxide is inevitably formed on the surfaces of the bumps 13a.

As shown in FIG. 3C, a flux 16 is applied to the semiconductor chip 11 and bumps 13a, which are then heated to 350°C in a non-oxidizing atmosphere. As a result, as shown in FIG. 3D, the bumps 13a melt so as to become spherical bumps 13 and the oxide film 15 is dissolved into the flux 16.

The result is then cleaned with triclene (trichloroethylene) for example, removing the oxide films 15 and exposing the spherical bumps 13 as shown in FIG. 3E. Examples of the actual dimensions and number of the bumps 13 are as follows: Each side of the semiconductor chip is more than 10 millimeters, the diameter of each bump 13 is 10 µm, and the number of bumps 13 formed amounts to several thousands on each semiconductor chip.

The bump formation step may also use deposition technology or another technology instead of the plating technology in the above-described first embodiment of the present invention.

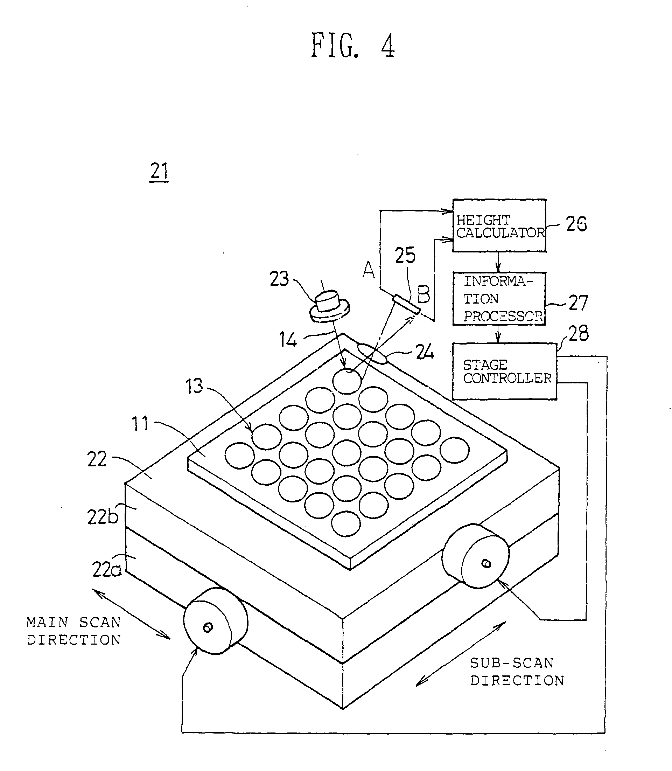

The next step is for the heights H of the bumps 13 to be measured by means of laser beams and the triangulation principle, as described below with reference to FIG. 4. The bump-height measurement equipment 21 shown in FIG. 4 is one example of equipment which may be used in the above bump-height measurement step.

The semiconductor chip 11 on which the bumps 13 have been formed is placed on a two-axis stage 22. A laser diode (LD) 23 irradiates the bumps 13 with laser beams 14. The light beams reflected from the bumps 13 are directed to a detector 25 by an image-formation lens 24. According to the output of the detector 25, a height calculator 26 calculates the height of the relevant bump 13 and the calculation result is stored in an information processor 27. After one bump 13 has been measured, the information processor 27 operates the two-axis stage 22 (including a main scan stage 22a and sub-scan stage 22b) through a stage controller 28 so that the equipment 21 can measure successively the heights of the subsequent bumps 13.

The height calculation performed by the height calculator 26 is based on the generally used criangulation principle. That is, the height calculator 26 uses the signals A and B output from the detector 25, which is, for example, made of a photodiode, due to the light beams received thereby, the magnification of the image-formation lens 24 and irradiation angles of the laser beams 14. The detector 25, has the property that each of the output signals A and B indicates a distance value (electric current, for example) inversely proportional to the distance between the position at which the light beam is currently incident on the detector 25 and the end thereof. The ratio between the distance values of the signals A and B leads to the above light-beam incident position on the detector. The height calculator 26 thus calculates the light-beam incident positions which are then used to calculate the height H of the bump 13 through the triangulation principle. The bump heights H are assumed be distributed between 95 µm through 115 µm, for example.

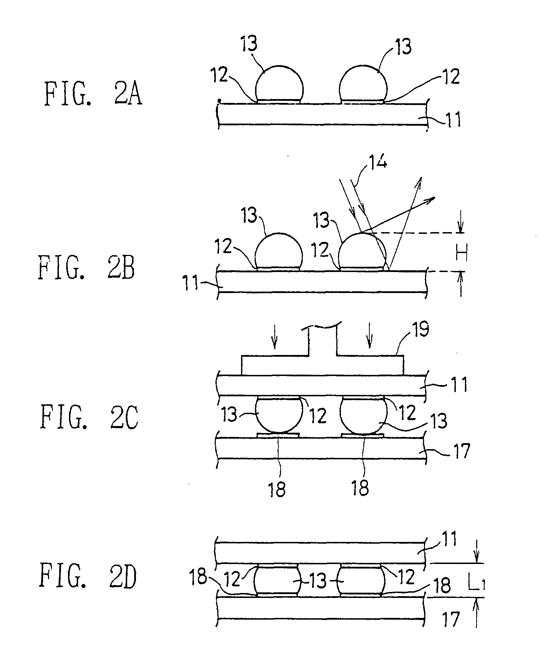

Returning to the general process shown in FIGS. 2A-2D, in FIG. 2C, a circuit substrate 17 to which the semiconductor chip 11 is to be joined, has electrodes 18 (of Au for example) previously formed thereon which match the bumps 13 on the chip 11. Thus, proper positioning of the chip 11 on the substrate 17 causes the bumps 13 to meet the electrodes 18. Then, a pressing mechanism 19 is used to press the chip 11 with a force of 3 kgf, for example, downward in so as to provisionally fix the chip 11 onto the substrate 17. This pressing operation is performed to result in a bump height (space between the chip and substrate as shown in FIG. 2D) L₁ of 90 µm in the above assumed case where the bump heights H are distributed between 95 µm and 115 µm. This provisional fixing step using the press fixing method is preferably performed at 250°C ambient temperature for 3 minutes.

In the actual experiment performed according to the above procedure, the resulting provisional chip and substrate assembly did not have any positioning errors while the assembly was carried to a position where the solder bonding step described below was performed thereon.

In the solder bonding step, the assembly is heated to 400°C ambient temperature in a N₂(80%)+H₂(20%) atmosphere for 10 minutes, for example, without using flux (FIG. 2D). As a result, the bumps 13 melt so that the semiconductor chip 11 is joined (flip chip bonding) to the circuit substrate 17 with the space (at the distance) L₁=90 µm.

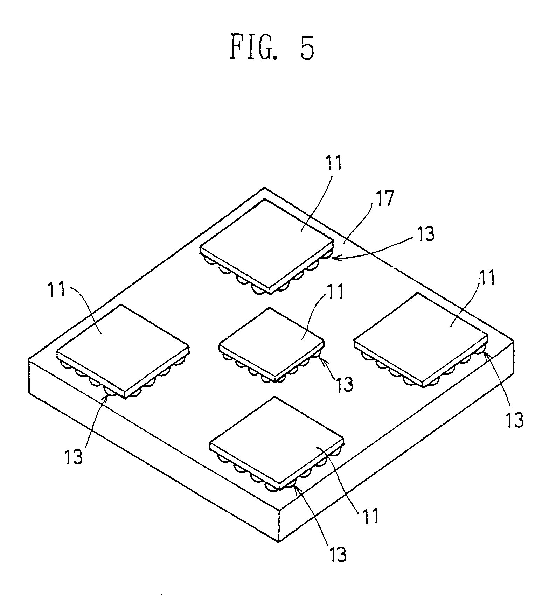

Referring to FIG. 5, the flip-chip bonded semiconductor unit is now described. The state of the unit not shown in FIG. 5 is substantially identical to that shown in FIG. 2D but FIG. 5 shows a perspective view of the unit. As an example, five semiconductor chips 11 are bonded in the flip chip bonding manner on the circuit substrate 17 by means of the bumps 13.

Even if the heights of the bumps of the chips 11 are different from one another before the chips are provisionally fixed on the substrate 17, all of the bumps' free ends can be made to come in contact with the corresponding electrodes 18 on the circuit substrate 17. This contact state can be achieved by the provisional fixing step (using the press fixing method) making the bump heights less than before the step is performed. As a result, sure bonding may be achieved. Furthermore, removing the oxide films 15 from the surfaces of the bumps 13 (13a) as described above provides sufficient wetting conditions between the bumps' free ends and the electrodes 18 so that they can be bonded together without using flux, so that proper bonding may be achieved. Consequently, a reliable semiconductor unit may be obtained.

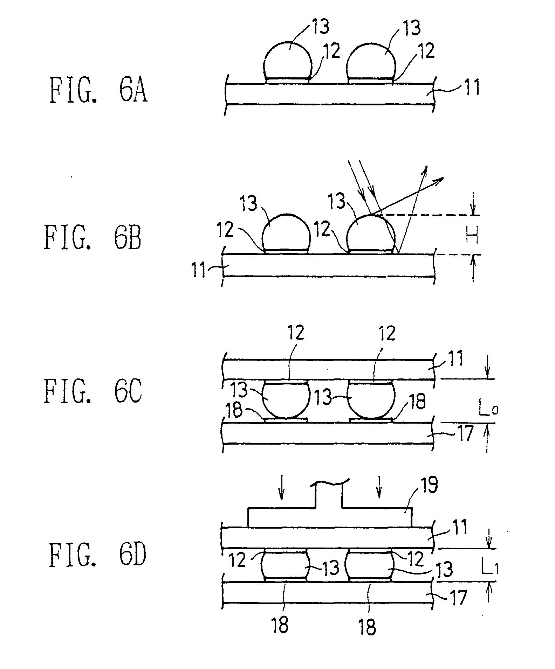

Referring now to FIGS. 6A-6D, a second embodiment of the process of the present invention will now be described. The steps associated with FIGS. 6A and 6B are similar to those of FIGS. 2A and 2B respectively and the construction of the circuit substrate 17 having the electrodes 18 provided thereon is similar to that used in the process of FIGS. 2A-2D. Thus, the description of this omitted.

If In solder is used instead of the above-mentioned Sn-95Pb solder for forming the bumps 13, the heights of the bumps 13 are distributed between 50 µm and 70 µm, for example, as measured using a technique and measurement equipment such as that described above.

In FIG. 6C, the bumps 13 formed on the electrode pads 12 are made to meet the corresponding electrodes 18 prepared on the circuit substrate 17 by positioning chip 11 and the substrate 17 properly with respect to one another. Then, using the viscosity of the *In* in the bumps 13, the bumps' free ends are press fixed on to the electrodes 18 at the normal ambient temperature. The press fixing is performed so that the resulting distance L₀ shown in FIG. 6C between the chip 11 and substrate 17 measures 60 µm in the case where the previously measured bump heights are distributed between 50 µm and 70 µm. In the actual experiment performed according to the above procedure, the resulting provisional chip and substrate assembly did not have any positioning errors while the assembly was carried to a position where the subsequent solder bonding step was performed thereon.

In the solder bonding step, the assembly is heated to 260°C ambient temperature in a N₂(80%)+H₂(20%) atmosphere for 10 minutes, while the pressing mechanism 19 applies 20 gf downwardly onto the chip 11, as shown in FIG. 6D. As a result, the bumps 13 melt so that the semiconductor chip 11 is joined in a solder bonding manner to the circuit substrate 17 with the space L₁=40 µm. As a result, all of the bumps' 13 free ends should be firmly joined to the corresponding electrodes 18 without any poor bonding occurring.

Thus, even if the heights of the bumps of the chips 11 are different from one another before the chips are provisionally fixed on the substrate 17, all of the bumps' free ends can be made to come in contact with the corresponding electrodes 18 on the circuit substrate 17. This contact state can be achieved by the solder bonding step (under the control by means of the pressing mechanism) making the bump heights less than before the step is performed. As a result, sure bonding may be achieved. Consequently, a reliable semiconductor unit may be obtained.

The above described oxide-film removal step is not limited to using flux as described in the above embodiments. Other methods using ion-etching or the like may also be applied. Also, the bump formation step is not limited to employing the Sn-95Pb or In solder for the bumps 13 as described in the above embodiments. Other methods employing alloys including In, Pb, Sn, Bi, Ag, G or the like may be applied.

Furthermore, the provisional fixing step may further comprise forming dummy electrode pads and bumps on the semiconductor chip 11 and forming dummy electrodes at the corresponding positions on the circuit substrate 17. The dummy electrode pads, bumps and dummy electrodes are produced at vacant positions, and are used only for provisionally fixing the semiconductor chip 11 to the circuit substrate 17 and not for establishing any actual electrical circuits. The solder bonding step may comprise using VPS (vapor phase soldering) technology. The bumps 13 may be formed on the circuit substrate 17 instead of on the semiconductor chip 11 as described above.

The present invention is not limited to the above described embodiments, and variations and modifications may be made without departing from the scope of the present invention.

## Claims

1. A semiconductor unit fabrication process, comprising:
forming a predetermined plurality of bumps (13) on one (11) of two components (11,17);
removing an oxide film (15) formed on the bumps;
measuring the respective heights (H) of all of the bumps (13);
connecting the two components (11,17) via the bumps (13) by bringing the two components (11,17) to within a distance L₁ of each other as a result of applying a predetermined pressure to the two components (11, 17), the distance L₁ being determined using the result of the measuring and being equal to or less than the smallest measured bump height (H) so that all of the bumps (13) come into contact with the two components (11, 17) and all of the bumps have the same height,
wherein the distance L₁ is determined for each semiconductor unit fabricated.

2. A process as claimed in claim 1, wherein the two components (11,17) are connected by (i) press fixing the two components (11,17) together, and (ii) melting the bumps (13) in a predetermined atmosphere so that the bumps (13) firmly connect the two components (11,17) together, the distance L₁ being established by at least one of step (i) and step (ii).

3. A process as claimed in any preceding claim, wherein one of the two components (11,17) comprises a substrate (17) and the other comprises an electronic device (11).

4. A process as claimed in any preceding claim, wherein the distance L₁ is established by applying a predetermined load to at least one (11) of the two components (11,17).

## Patentansprüche

1. Halbleitereinheit-Herstellungsprozeß, der folgende Schritte umfaßt:
Bilden einer vorbestimmten Vielzahl von Bondhügeln (13) auf einer (11) von zwei Komponenten (11, 17);
Entfernen eines Oxidfilms (15), der auf den Bondhügeln gebildet ist;
Messen der jeweiligen Höhen (H) aller Bondhügel (13);
verbinden der zwei Komponenten (11, 17) durch die Bondhügel (13), indem die zwei Komponenten (11, 17) in einen gegenseitigen Abstand L₁ als Resultat des Anwendens eines vorbestimmten Drucks auf die zwei Komponenten (11, 17) gebracht werden, welcher Abstand L₁ unter Verwendung des Resultats des Messens bestimmt wird und gleich oder kleiner als die kleinste gemessene Bondhügelhöhe (H) ist, so daß alle Bondhügel (13) mit den zwei Komponenten (11, 17) in Kontakt gelangen und alle Bondhügel dieselbe Höhe haben,
bei dem der Abstand L₁ für jede Halbleitereinheit, die hergestellt wird, bestimmt wird.

2. Prozeß nach Anspruch 1, bei dem die zwei Komponenten (11, 17) verbunden werden (i) durch gemeinsame Preßfixierung der zwei Komponenten (11, 17) und (ii) durch Schmelzen der Bondhügel (13) in einer vorbestimmten Atmosphäre, so daß die Bondhügel (13) die zwei Komponenten (11, 17) fest zusammen verbinden, wobei der Abstand L₁ wenigstens durch einen von dem Schritt (i) und dem Schritt (ii) hergestellt wird.

3. Prozeß nach irgendeinem vorhergehenden Anspruch, bei dem eine der zwei Komponenten (11, 17) ein Substrat (17) umfaßt und die andere eine elektronische Vorrichtung (11) umfaßt.

4. Prozeß nach irgendeinem vorhergehenden Anspruch, bei dem der Abstand L₁ hergestellt wird, indem eine vorbestimmte Last auf wenigstens eine (11) der zwei Komponenten (11, 17) angewendet wird.

## Revendications

1. Procédé de fabrication d'une unité semiconductrice comprenant les opérations suivantes :
former une pluralité prédéterminée de bosses (13) sur l'un (11) de deux composants (11, 17) ;
retirer une pellicule d'oxyde (15) formée sur les bosses ;
mesurer les hauteurs respectives (H) de toutes les bosses (13) ;
connecter les deux composants (11, 17) par l'intermédiaire des bosses (13) en mettant les deux composants (11, 17) moins d'une distance L₁ l'un de l'autre du fait de l'application d'une pression prédéterminée aux deux composants (11, 17), la distance L₁ étant déterminée à l'aide du résultat de la mesure et étant égale ou inférieure à la plus petite hauteur de bosse (H) mesurée, de façon que toutes les bosses (13) viennent en contact avec les deux composants (11, 17) et que toutes les bosses aient la même hauteur,
où la distance L₁ est déterminée pour chaque unité semiconductrice fabriquée.

2. Procédé selon la revendication 1, où on connecte les deux composants (11, 17) (i) en fixant ensemble, à la presse, les deux composants (11, 17), et (ii) en faisant fondre les bosses (13) dans une atmosphère prédéterminée de façon que les bosses (13) connectent solidement les deux composants (11, 17) ensemble, la distance L₁ étant établie par au moins l'une des opérations (i) et (ii).

3. Procédé selon l'une quelconque des revendications précédentes, où l'un des deux composants (11, 17) comprend un substrat (17) et l'autre comprend un dispositif électronique (11).

4. Procédé selon l'une quelconque des revendications précédentes, où on établit la distance L₁ en appliquant une charge prédéterminée à au moins l'un (11) des deux composants (11, 17).
